# EUROPEAN PATENT APPLICATION

(11) **EP 2 053 662 A2**
(43) Date of publication of application: **29.04.2009**
(21) Application number: 08008491.6
(22) Date of filing: 06.05.2008
(51) Int. Cl.: H01L 31/048, H01L 31/05

(54) **Photovoltaic tile assembly**

(30) Priority: 09.10.2007 SG 200716871
(71) Applicant: Dragon Energy Pte. Ltd., Singapore 048623 (SG)
(72) Inventor: Nightingale, Christopher George Edward, Singapore 259983 (SG)
(74) Representative: Hasler, Erich

(57) **Abstract**

A photovoltaic tile assembly 10 comprises a base tile 12 having at least one solid region 14 through which a mechanical fastener is driven for fastening the base tile 12 to an underlying roof structure. The assembly 10 further comprises one or more cover tiles 16 each having a photovoltaic cell 18 for converting solar energy into electricity. The cover tiles 16 are electrically and mechanically coupled to a corresponding base tile 12 by electrical connection posts 22. The posts 22 are supported within the base tile 12 and have a first end 24 that contacts with and provides electrical connection with respective output terminals 20 of the cover tile 16. Additionally, the first end 20 penetrates through the cover tile 16 to provide mechanical attachment of the cover tile 16 to a base tile 12. Each post 22 also has a second end 26 that is electrically coupled to an electrical connection tube 28 to facilitate electrical coupling of the cover tiles 16 to a power management system. Tubes 28 are provided with electrical connectors 76 and 78 at opposite axial ends to enable electrical connection with adjacent tubes 28 in adjacent tile assemblies 10.

## Description

### Field of the Invention

The present invention relates to a photovoltaic tile assembly particularly, though not exclusively, for use on a roof of a building for converting solar energy to electrical energy.

### Background of the Invention

It is well known to use solar panels mounted on a roof of a building to provide electrical energy to supplement the energy needs of the building. Such panels are fitted to an existing roof over the existing roof covering. That is, the panels do not in themselves replace or act as a waterproof covering for the roof.

It is also known to construct photovoltaic tiles that can also act as a covering for the roof itself.

One example of such a tile is disclosed in International publication no. WO 00/30184 which describes a photovoltaic roof tile composed of a base tile and a face tile. A cavity is formed between the base tile and the face tile for seating a photovoltaic cell. The tile has opposed side margins that allow side by side engagement of tiles to provide waterproof joins between tiles in the same row. Waterproofing between tiles in vertically adjacent rows is achieved in a conventional manner by overlapping an upper portion of a lower tile with a lower portion of an upper tile. This specification also describes the provision of predrilled holes within the tile to receive nails for securing the tiles to a substructure.

A further example of a photovoltaic tile that can act as a roof covering is disclosed in International publication no. WO 2005/045328. This specification discloses a tile comprising a base and a photovoltaic laminate connected to the base. Each tile has lateral protrusions to engage laterally adjacent tiles to provide lateral waterproofing. Waterproofing between tiles in vertically adjacent rows is again achieved in a conventional manner by the overlapping of an upper tile with a lower tile.

It is to be understood that, if any prior art publication is referred to herein, such reference does not constitute an admission that the publication forms a part of the common general knowledge in the art, in Australia or any other country.

### Summary of the Invention

According to a first aspect of the present invention there is provided a photovoltaic tile assembly comprising:
a base tile having at least one solid region through which a mechanical fastener is driven for fastening the base tile to an underlying structure;
one or more cover tiles, each cover tile having at least one photovoltaic cell and electrical output terminals; and,
one or more electrical connection posts supported in the base tile, each connection post having a first end for electrical connection with an output terminal of a cover tile, wherein the first end penetrates through the cover tile to further provide mechanical attachment of the cover tile to the base tile.

According to a further aspect of the invention there is provided a photovoltaic tile assembly comprising:
a base tile having at least one solid region through which a mechanical fastener is driven for fastening the base tile to an underlying support structure;
one or more cover tiles each having a photovoltaic cell and electrical output terminals, the or each cover tile releasably connected to the base tile to cover the base tile including the or each solid region; and,
a tile coupling system providing waterproof coupling between adjacent tiles, the tile coupling system comprising laterally extending tongues running along one side of each tile and a longitudinal groove running along an other side of the tile adjacent to the tongue, the tongues and grooves and configured so as to engage with grooves and tongues respectively of adjacent tiles to form a waterproof seal therebetween.

According to a further aspect of the present invention there is provided a photovoltaic tile assembly comprising:
a base tile;
one or more cover tiles attached to an upper surface of the base tile, the or each cover tile having a photovoltaic cell with electrical output terminals; and,
an electrical connection system enabling electrical connection between cover tiles of the same or different base tiles, the electrical connection system comprising: a plurality of electrical connection posts supported in the base tile, each post having first and second ends, the first end being configured to electrically connect with an output terminal of a cover tile; and, one or more electrical connection tubes, each tube having an opening to engage and provide electrical connection with the second end of a post, and end connectors at each axial end of the tube, the end connectors configured to provide electrical connection between ends of adjacent tubes.

According to a further aspect of the invention there is provided an electrical connection system for providing electrical connection between first and second devices, the electrical connection system comprising:
at least one electrical connection post, the or each post having first and second ends, the first end configured to electrically connect with a first device; and,
at least one electrical connection tube, the or each tube having an opening to engage and provide electrical connection with a second end of respective posts, and end connectors at each axial end of the tube, the end connectors configured to electrically connect with end connectors of an adjacent tube wherein a second device can be electrically connected with the end connector of a tube and thereby electrically connected with the first device.

The opening in each tube may comprise a longitudinal slot for receiving the second end of a post, the longitudinal slot being open at least one end of the tube. However in an alternate embodiment, the longitudinal slot opens onto both ends of the tube.

The opening may further comprise at least one secondary slot extending from the longitudinal slot, the or each secondary slot configured to receive and provide electrical connection with the second end of a respective post.

The tube may further comprise a first conductor extending between respective end connectors and electrically coupled with a first group of secondary slots, and a second conductor extending between respective end connectors and electrically coupled with a second group of second slots, wherein the first and second conductors are electrically isolated from each other.

Each tube may be further provided with complementary couplings at each end to enable mechanical coupling between adjacent tubes.

The base tile may be provided with a plurality of holes extending perpendicular to a plane of the tile, each hole dimensioned relative to an electrical connection post so as to receive a post with an interference fit with the ends of the post protruding from the hole. Each electrical connection post may be provided with one or more circumferential recesses configured to receive a corresponding protrusion formed in the hole.

### Brief Description of the Drawings

An embodiment of the present invention will now be described by way of example only with reference to the accompanying drawings in which:
Figure 1 is a section elevation view of a base tile incorporated in an embodiment of a photovoltaic tile assembly in accordance with the present invention;
Figure 2 is a top elevation view of the base tile shown in Figure 1;

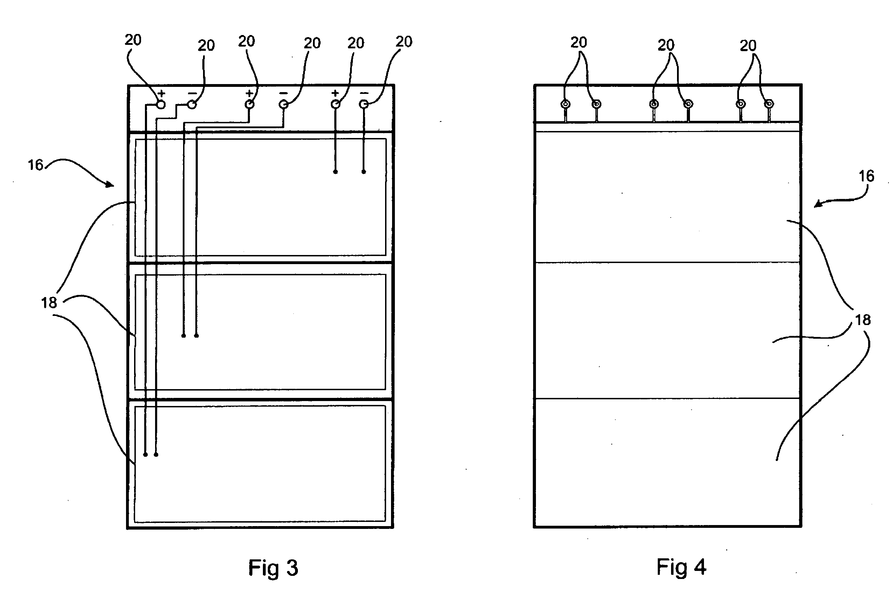

Figure 3 is a section elevation view of a cover tile incorporated in the photovoltaic tile assembly;
Figure 4 is a top elevation view of the cover tile shown in Figure 3;
Figure 5 is a lateral section view of the photovoltaic tile assembly;
Figure 6 is a transverse section view of the photovoltaic tile assembly;
Figure 7 is a schematic representation of an electrical connection post incorporated in the photovoltaic tile assembly;
Figure 8 is a perspective view of an electrical connection tube incorporated in the photovoltaic tile assembly;
Figure 9 is a plan view of the tube shown in Figure 8;
Figure 10 is a section view of a tube shown in Figures 8 and 9; and,
Figure 11 is a section view of a portion of a cover tile shown in Figures 3 and 4.

### Detailed Description of the Preferred Embodiments

Referring to the accompanying drawings, an embodiment of a photovoltaic tile assembly (hereinafter referred to as simply "assembly") 10 comprises a base tile 12 having at least one (and in this particular embodiment, four) solid region 14 through which a mechanical fastener such as a nail or screw is driven for fastening the base tile 12 to an underlying structure such as a roof structure. It is envisaged that the solid region will not necessarily be predrilled or formed with holes for the mechanical fasteners to allow an installer to select the best location for the fasteners. However in a variation of this embodiment one or more such holes can be formed.

The assembly 10 further comprises one or more cover tiles 16 each having a photovoltaic cell 18 for converting solar energy into electricity. The cell 18 generates an electric current that is made available at positive and negative output terminals 20a and 20b respectively, (hereinafter referred to in general as "output terminals 20").

Two forms of cover tile 16 may be provided. In a first from of cover tile 16 the cell 18 is provided on substantially the whole surface area of the tile 16 except the portion of surface area having the output terminals 20. In a second form of cover tile 16 about one third of the surface area immediately below the output terminals 20 is left blank (ie without a photovoltaic cell 18) so that only about the lower two thirds of the surface area of the tile 16 is formed with the cell 18. As explained in greater detail below in the tile assembly 10, the cover tiles 16 overlap by one third of their surface area with the first form of cover tile 16 being uppermost and fully exposed while the underlying tile 16 is of the second form and has the upper third of its surface area covered.

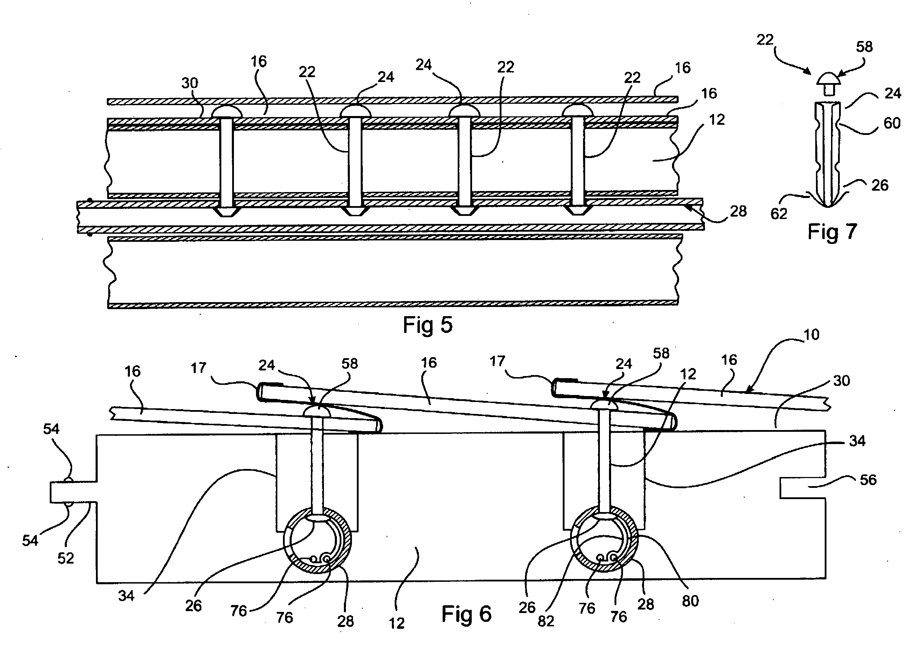

The cover tiles 16 are electrically and mechanically coupled to a corresponding base tile 12 by electrical connection posts (hereinafter referred to in general as "posts") 22. The posts 22 are supported within the base tile 12 and have a first end 24 that contacts with and provides electrical connection with respective output terminals 20 of a cover tile 16. In addition the first end 24 penetrates through the cover tile 16 to provide mechanical attachment of the cover tile to the base tile 12. As explained in greater detail below particularly with reference to Figure 6, each post 22 also has a second end 26 that is electrically coupled to an electrical connection tube 28 that facilitates the electrical coupling of the cover tile 16 to a power management system (not shown) which may include storage batteries.

Looking at the components of the assembly 10 in more detail, the base tile 12 is typically in the configuration of a square plate having a planar and substantially continuous upper surface 30. The continuity of the upper surface 30 is interrupted only by the extension of the posts 22 through the surface 30 in a direction perpendicular to the plane of the surface 30. The posts 22 are in this embodiment arranged in two parallel lines. As explained further below, a waterproof seal is formed about the posts 22 where they extend through the surface 30.

An under side 32 of the base tile 12 is formed with a plurality of walls or ribs dividing the underside 32 into a number of different sections. In this particular embodiment, each of the four corners of the base tile 12 is formed of solid material creating the solid portions 14 through which a mechanical fastener such as a nail or screw can be driven. A pair of parallel walls 34 extend between opposite sides 36 and 38 of the base 12 and in part form a boundary of the solid portions 14. The base further comprises a plurality of further walls 40 extending perpendicular to the walls 34 and which also bound respective sides of the solid portions 14. The walls 40 extend between respective adjacent sides 42 and 44 of the base tile 12 and the nearest wall 34. By this configuration, the under side 32 of the base 12 is formed with compartments 46 adjacent the sides 42 and 44 and a larger central compartment 48.

The compartments 46 and 48 may be left as unfilled voids. However it is envisaged that the compartments 46 will contain a thermal insulation material and the compartment 48 may optionally contain an electrical power storage means such as a battery 50 with any remaining space in the void 48 filled with insulating material. In the event that the battery is not included, the entire compartment can be filled with thermal insulation material. By provision of the thermal insulating material the base tile 12 is able to perform an insulation function. This function may additionally or alternately be provided by using a thermal insulating material to manufacture the base tile 12. The walls 34 and 40 may also be provided with longitudinal extending recesses for seating the connection tubes 28. The tubes 28 are of a length equal to the recess in the walls 34 and 40 in which they are seated.

The assembly 10 also comprises a tile coupling system for providing a water proof coupling between adjacent tile assemblies. In this embodiment the coupling system comprises a laterally extending tongue 52 that runs along adjacent sides 38 and 44 of the base tile 12. Each tongue 52 is further provided with a longitudinally extending rubber seal 54. The tile coupling system also comprises complementary grooves 56 extending longitudinally along adjacent sides 36 and 42 of a base tile 12. The provision of the tongues 52 and grooves 56 enables a tile assembly 10 to be connected in a waterproof manner on all four sides to other identical tile assemblies 10.

With particular reference to figures 5, 6 and 7, it can be seen that each post 22 is the form of a tube having an opening at the first end 24 for receiving an end cap in the form of a rubber grommet 58. The end cap or grommet 58 is formed of a resilient material such as rubber and retained in the end 24 by one or both of an interference fit and the use of adhesives. The post 22 is itself made of an electrically conductive material such as steel or stainless steel and is formed with a pair of circumferential and axially spaced apart grooves or recesses 60. A conductive spring' 62 is electrically and mechanically coupled to the end 26.

The recesses 60 receive corresponding protrusions formed in the holes formed in the base tile 12 into which the posts 22 are inserted. The protrusions and grooves or recesses 60 are arranged to form a water proof seal between each post 22 and the base tile 12. More particularly, the posts 22 are pushed into corresponding holes in the base tile 12 so that the end 24 protrudes from the surface 30 to thereby facilitate connection with the cover tile 16, while the end 26 protrudes into the recess formed in the walls 34 to enable coupling with respective connection tubes 28.

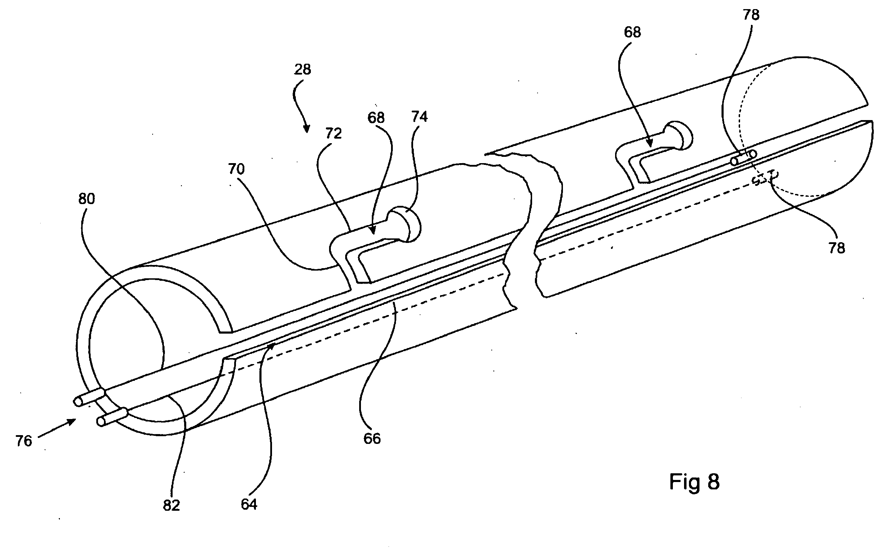

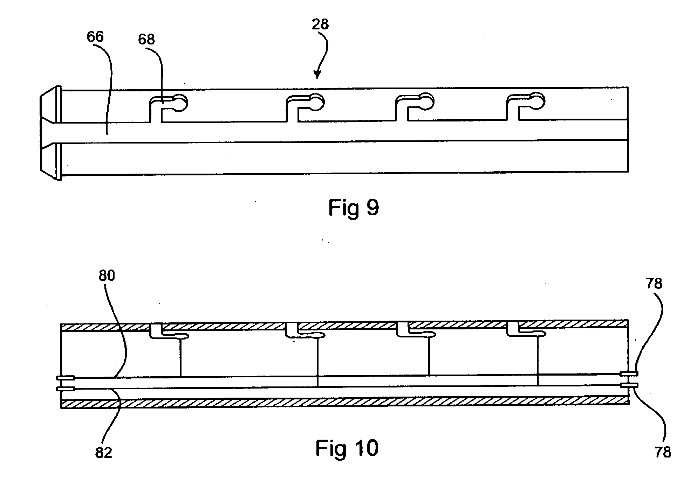

Figures 6, 8, 9 and 10 depict in more detail the nature of the electrical connection tubes 28. The tube comprises an opening 64 to engage and provide electrical connection with the second ends 26 of respective posts 22. Each opening 64 comprises a longitudinal slot 66 which, in this embodiment extends for the entire length of the tube 28, together with a plurality of secondary slots 68 that extend from the longitudinal slot 66. The secondary slots 68 comprise a first length 70 that extends in a circumferential direction, and a second length 72 that extends in the axial direction. The second length 72 terminates in a circular portion 74.

Electrical end connectors 76 and 78 are provided at each axial end of a connection tube 28 to enable end to end electrical connection between adjacent tubes 28. In this regard, the end connectors 76 may be in the form of spring loaded or biased male plugs while the end connectors 78 may be in the form of female sockets. The male plugs 76 can be retracted to be substantially flush with the adjacent ends of its corresponding tube 28 during installation of the base tiles 12, and subsequently be extended by spring action into corresponding sockets 78.

A first conductor 80 connects one of the end connectors 76 to one of the end connectors 78 and also provides electrical coupling with a group of the secondary slots 68. Similarly, a second conductor 82 provides electrical connection between the other end connectors 76 to 78 and to a second group of the secondary slots 68. More particularly, the conductors 80 and 82 provide electrical connection to alternate slots 68 which are electrically connected with positive and negative terminals 20a and 20b of the PV cells 18. Thus in effect, the positive terminals 20a of each of the PV cells 18 is electrically coupled with the conductor 80 while the negative terminals 20b of each of the PV cells 18 is electrically connected with the conductor 82.

Each of the axial ends of the tube 28 can be formed in a manner to facilitate mechanical coupling with an adjacent tube. Ideally this will be by way of an interference fit, or "click connection" between adjacent tubes 28.

It is envisaged that the base tiles 12 will be provided in packs together with a pack of grommets 58, with the cover tiles 16 provided in separate packs.

To install the tile assemblies 10 on the roof frame structure 14, the posts 22 (without the grommets 58) are inserted into corresponding holes formed in the base tiles 12 so that the ends 24 protrude beyond the surface 30 and the ends 26 protrude into the recesses or grooves formed in the walls 34 and 40. Next an individual base tile 12 is attached to a roof structure by hammering nails through the solid portions 14. Respective connection tubes 28 are then placed in the recesses in the walls 34 and 40 with the ends 26 of the posts 22 located in the slots 66 and aligned with the secondary slots 68. The tubes are then rotated and slid to lock them in place with the ends 26 of the posts 22 engaged in respective circular portions 74 and the spring 62 pressing on an under surface of the circular portion 74 to facilitate electrical contact with a corresponding conductor 80 or 82.

This process is then repeated for the next adjacent base tile 12, which, after the posts 22 have been inserted is pushed up against the previously laid base tile 12 so that the tongue 52 of one of the base tiles is received in the groove 56 of the other base tile 12. During the installation of the connection tube 28 in the adjacent tile the male plugs 76 of one tube may be retracted while the connection tube 28 of the adjacent base tile 12 is rotated into place. Thereafter the plugs 76 will mate with and extend into the female socket 78 assuming correct alignment of the tubes 28 of the previously laid and adjacent tiles.

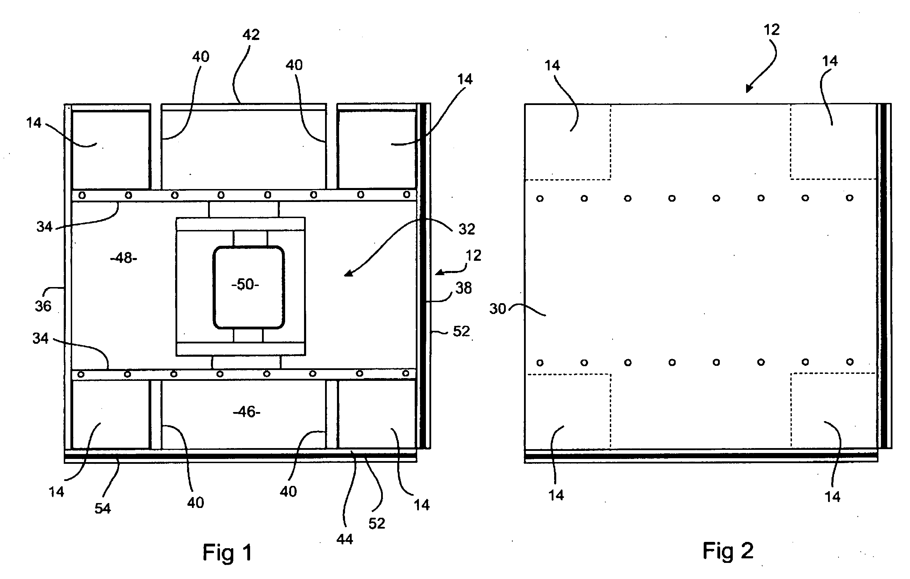

In perhaps a simpler installation process, the base tiles 12 may be assembled to include the posts 22 and the connection tubes 28 prior to being fixed to the roof frame structure 14. In this process when the next tile 12 is laid an installer need only engage the tongues 52 and groove 56, and the male plugs 76 with the female sockets 78 prior to fixing the next tile 12 to the roof frame structure 14.
Once the base tiles 12 have been laid and secured in place the cover tiles 16 are simply clipped onto the corresponding base tiles 12 by pushing the ends 24 through corresponding holes formed in the cover tile 16 and then pushing the grommets 58 into the ends 24 of the posts 22. These holes correspond with the output terminals 20 of the cover tiles 16. As opposite ends of each of the connecting tubes 28 are in electrical contact with each other by virtue of coupling of the connectors 76 of one tube with the connectors 78 of an adjacent tube, electrical connection is provided continuously along each row of tile assemblies 10. Electrical connection can then be provided with an adjacent row by use of similar tube connectors 28 seated in recesses formed in the walls 70 (see Figure 1).

The cover tiles 16 are dimensioned and configured to vertically overlap each other by about one third of their surface area as in a traditional shingle or tile roof so that a lower portion of one tile overlaps an upper portion of a vertically adjacent but lower tile. Further, a lower portion of a lowest cover tile 16 on a particular base tile 12 will overlap an upper portion of an uppermost over tile 16 on a vertical adjacent but lower base tile 12. Additionally the cover tiles 16 will be made from water proof materials. Accordingly the cover tiles 16, laid in this manner, will in effect provide a second water proof layer for the roof structure and additional thermal insulation.

As depicted in Figures 5 & 6 the lower portion of each tile rests on and is cushioned by the line of grommets 58 of the underlying cover tiles 16. In addition when attaching the cover tiles 16, conventional tile clips or hooks 17 may be inserted between adjacent cover tile 16 which hook over a bottom edge of an overlying tile 16 and hook under the upper edge of an adjacent underlying tile.

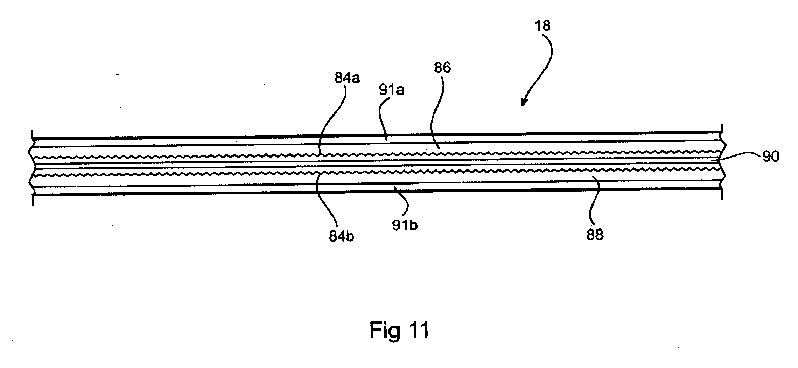

The PV cells 18 may be of conventional construction. However to enhance efficiency, a PV cell 18 as depicted in Figure 11 may be used which comprises a plurality of layers of photovoltaic material 84a, 84b that absorb different frequencies of light where a one way mirror film 86 is provided on a side of the cell 18 incident to incoming light and located above the layer 84a, with a reflector 88 provided in a layer below the layer 84b and facing the one way mirror film 86. In this way, light passing into the cell 18 through the one way mirror 86 is continually reflected through the photovoltaic layers 84a and 84b between the one way mirror 86 and the reflecting surface 88. An optically transparent separating layer 90 may be provided between the photovoltaic layers 84a and 84b. Additionally protective films or layers 91a and 91b are provided on opposite sides of the cell 18 adjacent the mirror film 86 and the reflector 88 respectively.

Modifications and variations in the tile assembly 10 that would be obvious to a person skilled in the art are deemed to be within the scope of the present invention, the nature of which is to be determined from the above description and the appended claims.

In the claims of this application and in the description of the invention, except where the context requires otherwise due to express language or necessary implication, the words "comprise" or variations such as "comprises" or "comprising" are used in an inclusive sense, i.e. to specify the presence of the stated features but not to preclude the presence or addition of further features in various embodiments of the invention.

## Claims

1. A photovoltaic tile assembly comprising:
a base tile having at least one solid region through which a mechanical fastener is driven for fastening the base tile to an underlying support structure;
one or more cover tiles each having at least one photovoltaic cell and electrical output terminals, the or each cover tile connected to the base tile to cover the base tile including the or each solid region; and,
a tile coupling system providing waterproof coupling between adjacent tiles, the tile coupling system comprising laterally extending tongues running along one side of each base tile and a longitudinal groove running along another side of the base tile adjacent to the tongue, the tongues and grooves configured so as to engage with grooves and tongues respectively of adjacent tiles to form a waterproof seal therebetween.

2. The photovoltaic tile assembly according to claim 1 further comprising one or more electrical connection posts supported in the base tile, each connection post having a first end for electrical connection with an electrical output terminal of a cover tile.

3. The photovoltaic tile assembly according to claim 2 wherein the first end of each post extends into a corresponding one of the cover tiles to provide mechanical attachment of that cover tile to the base tile.

4. A photovoltaic tile assembly comprising:
a base tile having at least one solid region through which a mechanical fastener is driven for fastening the base tile to an underlying structure;
one or more cover tiles, each cover tile having at least one photovoltaic cell with at least one electrical output terminal; and,
one or more electrical connection posts supported in the base tile, each connection post having a first end for electrical connection with an electrical output terminal of a cover tile, wherein the first end extends into the cover tile to further provide mechanical attachment of the cover tile to the base tile.

5. The photovoltaic tile assembly according to any one of claims 2 - 4 further comprising at least one electrical connection tube, each electrical connection tube having an opening to engage and provide electrical connection with a second end of the post.

6. The photovoltaic tile assembly according to claim 5 wherein each tube comprises at least one end connector at each of its opposite ends whereby the end connectors at one end of one tube can electrically couple with the end connectors at one end of another tube.

7. A photovoltaic tile assembly comprising:
a base tile;
one or more cover tiles attached to an upper surface of the base tile, the or each cover tile having at least one photovoltaic cell with electrical output terminals; and,
an electrical connection system enabling electrical connection between cover tiles of the same or different base tiles, the electrical connection system comprising: a plurality of electrical connection posts supported in the base tile, each post having first and second ends, the first end being configured to electrically connect with an output terminal of a cover tile; and, one or more electrical connection tubes, each tube having an opening to engage and provide electrical connection with the second end of a post, and end connectors at each axial end of the tube, the end connectors configured to provide electrical connection between ends of adjacent tubes.

8. The photovoltaic tile assembly according to any one of claims 2 - 7 wherein the or each electrical output terminal comprises a hole formed in its corresponding cover tile and wherein the first end of a connection port extends into the hole.

9. The photovoltaic tile assembly according to claim 8 further comprising a cap for each post, the cap and the first end of the post configured to engage each other, the cap fitting over the cover tile to thereby retain a corresponding cover tile on the post and between the cap and the base tile.

10. The photovoltaic tile assembly according to any one of claims 2 - 7 wherein the base tile is provided with a hole for each of the posts, the holes in the base tile and the posts being relatively configured so that the posts are engaged, and thereby supported, by the base tile.

11. The photovoltaic tile assembly according to any one of claims 2 - 10 wherein a waterproof seal is formed between the posts and the base tile.

12. The photovoltaic tile assembly according to any one of claims 2 - 11 wherein the posts are formed with at least one recess with at least one circumferential groove and, the base tile is provided with a protrusion to engage the recess or groove.

13. The system according to any one of claims 5 - 12 wherein the opening in each tube comprises a longitudinal slot for receiving the second end of a post, the longitudinal slot being open at least one end of the tube.

14. The system according to claim 13 wherein the longitudinal slot opens onto both ends of the tube.

15. The system according to claim 13 or 14 further comprising at least one secondary slot extending from the longitudinal slot, the or each secondary slot configured to receive and provide electrical connection with the second end of a respective post.

16. The system according to claim 15 wherein the tube further comprises a first conductor extending between respective end connectors and electrically coupled with a first group of secondary slots, and a second conductor extending between respective end connectors and electrically coupled with a second group of second slots, wherein the first and second conductors are electrically isolated from each other.

17. The system according to any one of claims 5 - 16 wherein each tube is further provided with complementary couplings at each end to enable mechanical coupling between adjacent tubes.

18. The system according to any one of claims 6 - 17 wherein the or each end connector at one end of the tube comprises a first connector that can be moved between an extended and a retracted position.

19. The system according to claim 18 wherein the first connector is biased toward the extended position.

20. The system according to claim 18 or 19 wherein the or each end connector at an opposite end of the tube comprises a second connector for receiving a corresponding plug.

21. The system according to claim 20 wherein the first connector is a plug and the second connector is a socket.

22. The tile assembly according to any one of claims 1 - 21 wherein the base tile contains an electrical storage device electrically coupled to the photovoltaic cells.

23. The tile assembly according to any one of claims 1 - 22 wherein each base tile comprises one or more compartments containing a thermal insulating material.

24. The tile assembly according to any one of claims 1 - 22 wherein the base tile is made from a thermal insulating material.

25. The tile assembly according to any one of claims 1 - 24 wherein a plurality of cover tiles are attached to the base tile and wherein at least one cover tile partially' overlaps another cover tile.

26. The tile assembly according to any one of claims 1 - 25 wherein the cover tiles from a waterproof layer one the base tile.
